# EUROPEAN PATENT SPECIFICATION

(11) **EP 2 120 336 B1**
(45) Date of publication and mention of the grant of the patent: **14.07.2010**
(21) Application number: 08008936.0
(22) Date of filing: 14.05.2008
(51) Int. Cl.: H03G 3/20

(54) **Technique for controlling a gain of a receiver**
Verfahren zur Steuerung einer Empfängerverstärkung
Technique pour contrôler le gain d'un récepteur

(43) Date of publication of application: 18.11.2009
(73) Proprietor: Telefonaktiebolaget LM Ericsson (publ), 16483 Stockholm (SE)
(72) Inventor: Lipka, Dietmar, 92348 Berg (DE); Mueller-Weinfurtner, Stefan, 90409 Nürnberg (DE); Wachsmann, Udo, 91126 Schwabach (DE)
(74) Representative: Bratt, Hanna Catharina

(56) References cited:
- EP-A- 1 401 134
- US-A1- 2002 098 814
- US-A1- 2002 186 799
- US-A1- 2004 082 356
- US-A1- 2005 100 119

## Description

### Technical field

The invention generally relates to the field of controlling a gain of a receiver. In particular, the invention relates to a technique for controlling a receiver gain including an initial controlling measure and at least one further controlling measure.

### Background

State of the art mobile terminals, e.g. mobile terminals which are working in accordance with the Global System for Mobile communications (GSM) or Wideband Code Division Multiple Access (WCDMA) standards, use Automatic Gain Control (AGC) schemes in order to adjust the signal strength of received signals. Signal strength adjustment is necessary in mobile terminals since received signals are supplied within the mobile terminals to Analog-to-Digital Converters (ADC) having a limited signal strength input range. In order to keep the mean power of the received signals within the ADC input range, the AGC schemes automatically adjust the receiver gain based on the signal strength of the received signal.

For GSM and WCDMA mobile terminals, a Received Signal Strength Indication (RSSI), i.e. a measurement of the total signal strength of received signals, is used for controlling the receiver gain. RSSI can be used for AGC schemes in GSM mobile terminals because the signal strength of received signal bursts is constant. RSSI can also be used for AGC schemes in WCDMA mobile terminals, since in WCDMA telecommunication systems more than half of the total signal strength of received signals is derived from broadcast channels having constant power levels.

Next generation mobile terminals use Orthogonal Frequency Division Multiplex (OFDM) and similar transmission schemes such as Single-Carrier Frequency Division Multiple Access (SC-FDMA). Such transmissions schemes are standardized by the 3rd Generation Partnership Project (3GPP) under the term "Long Term Evolution" (LTE).

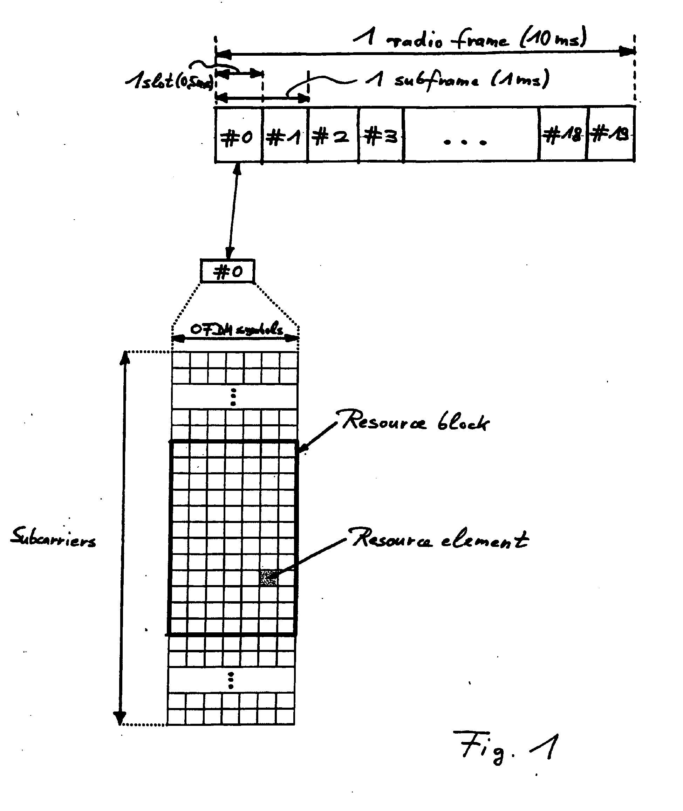

Fig. 1 shows an exemplary LTE frame structure and resource grid for an OFDM downlink transmission. In the frame structure shown in the upper section of Fig. 1, a 10 ms radio frame is divided into 20 equally sized time slots of 0,5 ms. A 1 ms sub-frame consists of two consecutive time slots. Thus, one radio frame contains 10 subframes.

In the lower section of Fig. 1, the structure of a downlink resource grid for one downlink time slot, time slot No. 0, is shown. The downlink resource grid consists of sub-carrier and OFDM symbol. The number of sub-carriers and OFDM symbols depends on the downlink bandwidth. Transmission data is allocated to mobile terminals by means of resource blocks. One resource block consists of a plurality of resource elements as shown in Fig. 1.

Depending on the required transmission data rate, one or more resource blocks can be allocated to a mobile terminal for each 1 ms sub-frame. This allocation is performed by a base station. In LTE telecommunication systems, the resource block allocation changes dynamically from sub-frame to sub-frame. Therefore, the signal strength of the received signals will also change dynamically from sub-frame to sub-frame. In particular, the signal strength may change from almost zero to full signal strength and vice versa from one sub-frame to the next sub-frame, i.e. every 1 ms. Moreover, the change of signal strength from sub-frame to sub-frame is not predictable.

Due to this unpredictable dynamic change of the signal strength, RSSI measurements are not suitable for controlling the receiver gain in LTE (and similar) mobile terminals.

Document US 2003/0091132 A1 discloses an AGC scheme and a receiver for use in a Time Division Duplex - Code Division Multiple Access (TDD-CDMA) system. The AGC scheme uses separate AGC processes for different stages of synchronization acquisition. During a first AGC process, a TDD-CDMA downlink beacon-function, in particular a peak power measurement over an entire time frame, is used for AGC control. In TDD-CDMA telecommunication systems, the beacon-function is always transmitted in a respective time slot at a known reference power level. The signal power received from the beacon-function is estimated by measuring the signal power received in a known midamble sequence.

However, in LTE telecommunication systems, all signals whose signal strength may principally be measured are corrupted by dynamic signals added to them. Thus, in LTE telecommunication systems, it is not possible to initially, e.g. when the mobile terminal is powered on or a cell reselection takes place, estimate the power of a received signal by measuring a signal strength received during a known transmission sequence.

Document US 2002/0098814 A1 concerns an apparatus for providing automatic gain control for use in a satellite terminal of a satellite communication system. For executing the automatic gain control, two different control schemes are disclosed, i.e., a first control scheme for an initial acquisition mode and a second control scheme for a subsequent tracking mode of operation. For the initial acquisition mode, the gain control is based on a measured peak power level of a received beacon signal.

Document EP 1401 134 A1 concerns an automatic gain control circuit. In one embodiment, a demodulation apparatus comprising a burst detector having autocorrelation and cross-correlation circuits is disclosed.

### Summary

Accordingly, there is a need for a technique for controlling a gain of a receiver which is avoiding at least some of the disadvantages outlined above.

This need is satisfied according to a first aspect by a method of controlling a receiver gain comprising the steps of receiving at least one signal, initially controlling the gain based on a correlation value of a first part of the received signal having a substantially constant signal strength, determining at least one timing-related parameter of the received signal based on the at least first part, identifying based on the at least one timing-related parameter at least a second part of the received signal having a substantially constant signal strength and further controlling the gain based on a measured signal strength of the identified second part.

A part of the received signal as understood herein may be a subset, a signal part, a sub-signal or any other sub-entity of the received signal.

When the receiver is powered on or a cell reselection takes place, e.g. during a cell search procedure, no information regarding signal strength levels or timing-related parameters like symbol timing, slot timing or frame timing are normally available within the receiver. Thus, in order to provide a control of the receiver gain in such or other situations, in particular during the timing acquisition phase of the receiver, the receiver gain is controlled based on a correlation value of a first part of the received signal having a substantially constant signal strength.

The correlation value may be determined based on a cross-correlation of the unknown first part of the received signal with a known reference signal or a number of known reference signals. The higher the correlation value, the more similar or more congruent the target and the reference signals are. The receiver gain may be initially set low and thereafter increased until a peak value of the correlation value is detected. Thus, a coarse control of the receiver gain can initially be provided.

For the correlation, i.e. for determining the correlation value, only a first part of the received signal having a substantially constant signal strength and not the signal strength of the entire received signal may be used, since in LTE and similar telecommunication systems, the signal strength of the entire received signal may vary dynamically from sub-frame to sub-frame.

Based on the correlation result, at least one timing-related parameter of the received signal is determined. By means of the at least one timing-related parameter, at least a second part of the received signal having a substantially constant signal strength can be identified. In other words, after the coarse initial controlling of the receiver gain, a second part of the received signal having a substantially constant signal strength is determined. Thereafter, the signal strength of the identified second part can be measured. Hence, after the initial controlling, further controlling of the gain of the receiver is based on the measured signal strength of the identified second part.

The first part of the received signal having a substantially constant signal strength may be a synchronisation signal comprising slot synchronisation information. In particular, the synchronisation signal may be a Primary Synchronisation Signal (P-SS) which provides the receiver with slot synchronisation information. The synchronisation signal comprising slot synchronisation information may be an LTE P-SS.

The second part of the received signal having substantially constant signal strength may comprise at least one of a synchronisation signal comprising slot synchronisation information, a synchronisation signal comprising frame synchronisation information, a transport channel comprising system information and a reference signal comprising channel estimation information.

The synchronisation signal comprising slot synchronisation information may be the P-SS described above. In this case, after initially controlling the receiver gain based on a P-SS correlation value, the P-SS signal strength may be measured and used for the further controlling of the receiver gain.

The synchronisation signal comprising frame synchronisation information may be a Secondary Synchronisation Signal (S-SS) providing the receiver with frame synchronisation information. For example, the synchronisation signal comprising frame synchronisation may be an LTE S-SS.

The transport channel comprising system information may be a Broadcast Channel (BCH) carrying system information in a cell. For example, the transport channel comprising system information may be an LTE BCH.

The reference signal comprising channel estimation information may be a Reference Signal (RSIG). For example, the reference signal comprising channel estimation information may be an LTE RSIG.

According to one aspect, the at least one timing-related parameter is associated with at least one of the slot timing, the frame timing and the symbol timing of the received signal. Thereby, the location of the at least second part of the received signal may be extracted from the received signal. Thus, the signal strength of the second part can be measured. The signal strength of the second part may be measured in the time domain.

According to a further aspect, the at least one timing-related parameter of the received signal is determined based on the first part and a further part of the received signal having a substantially constant signal strength. The further part may be a synchronization signal comprising frame synchronization information (e.g. S-SS) or another part of the received signal. For example, the at least one timing-related parameter may be determined based on a correlation of a synchronization signal comprising slot synchronization information (e.g. P-SS) and a correlation of a synchronization signal comprising frame synchronization information (e.g. S-SS).

The further controlling may comprise controlling the receiver gain based on a signal strength of at least one of the first part, the second part and a third part of the received signal having a substantially constant signal strength. When the timing-related parameters of the first part, the second part and the third part of the received signal are known after the correlation, the signal strength of these parts can be measured. For the further controlling of the receiver gain, any combination of the first, the second and the third part (or all three parts) can be used. The first part can be the synchronisation signal comprising slot synchronisation information (e.g. the P-SS), the second part can be the synchronisation signal comprising frame synchronisation information (e.g. the S-SS) and the third part can be the transport channel comprising system information (e.g. the BCH).

In addition to or instead of controlling the receiver gain based on a signal strength of at least one of the first part, the second part and the third part of the received signal, the receiver gain may also be further controlled after the initial controlling based on a signal strength of a further part of the received signal having a substantially constant signal strength. The further part may be the RSIG or a similar signal.

The method may comprise the further step of controlling the receiver gain based on a measured signal strength of a fourth part of a received signal having a substantially constant signal strength. The step may be performed after the further controlling step. Thereby, fine controlling of the receiver gain can be provided. The fourth part may be a reference signal, e.g. the RSIG, comprising channel estimation information.

According to a further aspect, the method may comprise the further steps of transforming the received signal into the frequency domain and identifying in the frequency domain the fourth or another part of the received signal. The received signal to be transformed may be a signal at full bandwidth. When full synchronisation is achieved and OFDM symbols can be detected, the fourth or further part of the received signal may, for example, be determined after a Fast Fourier Transformation (FFT). In case the fourth or further part is the RSIG, the controlling of the receiver gain based on a measured signal strength of the RSIG typically provides the most accurate controlling results, since the RSIG contains all information about the channel and allows accurate estimation of the receiver gain.

The initial controlling, the further controlling and the controlling based on a measured signal strength of the fourth part may be performed subsequent to each other. The further controlling and the controlling based on a measured signal strength of the fourth part may also be interchanged or combined into one controlling step.

According to a still further aspect, the receiver gain is controlled so that a target Signal-to-Noise-Ratio (SNR) value is reached. The target SNR value may be a minimum SNR value. The controlling of the gain of the receiver so that a minimum SNR value is reached may be used for the further controlling and the controlling based on a measured signal strength of the fourth part.

According to a further aspect, the method may comprise the steps of determining the total signal strength of the received signal and controlling the receiver gain based on the determined total signal strength. The determining of the total signal strength of the received signal may be provided in parallel to the initial controlling, the further controlling and the controlling based on a measured signal strength of the fourth part. The determining of the total signal strength may be provided after the ADC. Thereby, a reduction of the receiver gain is provided as soon as the maximum ADC level is reached. Consequently, all other signal strength measurements generate reasonable values even in case signal demodulation may be corrupted by a too low SNR. Thereby, ADC clipping and ADC overflow can be prevented.

The received signal may be narrow band filtered before the initial controlling. For example, P-SS, S-SS and BCH, which are located in the narrow band, can be filtered. The narrow band filtering may be performed after the ADC right before the initial controlling. Independent of the narrow band filtering, the received signal having full bandwidth may still be transformed in the frequency domain for controlling the receiver gain based on a measured signal strength of a fourth part of a received signal having a substantially constant signal strength.

The techniques presented herein can be practiced in the form of hardware, in the form of software and in the form of a combined hardware/software approach. As for a software aspect, a computer program product is provided. The computer program product comprises program code portions for performing one or more of the steps of the methods and techniques described herein when the computer program product is run on one or more components of a network. The computer program product may be stored on a computer readable recording medium.

As for a hardware aspect, an apparatus for controlling a gain of a receiver is provided. The apparatus comprises a receiving unit for receiving at least one signal, a first controlling unit for initially controlling the gain based on a correlation value of a first part of the received signal having a substantially constant signal strength, a determining unit for determining at least one timing-related parameter of the received signal based on the at least first part, a first identifying unit for identifying based on the at least one timing-related parameter at least a second part of the received signal having a substantially constant signal strength and a second controlling unit for further controlling the gain based on a measured signal strength of the identified second part.

The apparatus may further comprise a second identifying unit for identifying a third part of the received signal having a substantially constant signal strength, wherein the at least one timing-related parameter of the received signal is determined based on the identified first part and a further part of the received signal having a substantially constant signal strength.

In one implementation, the apparatus may further comprise a third controlling unit for controlling the receiver gain based on a measured signal strength of a fourth part of the received signal having a substantially constant signal strength.

According to a further hardware aspect, a mobile terminal comprising an apparatus for controlling a gain of a receiver, as described herein, is provided. The mobile terminal may be a mobile telephone, a network or data card, a Personal Digital Assistant (PDA) or any other communication device.

According to a still further hardware aspect, a base station comprising an apparatus for controlling a gain of a receiver, as described herein, is provided. The base station may be a NodeB.

### Brief description of the drawings

In the following, the invention will be described with reference to exemplary embodiments illustrated in the drawings, wherein
- Fig. 1: is a schematic diagram illustrating an LTE down link frame structure and a resource grid;
- Fig. 2: is a schematic block diagram illustrating an embodiment of a communication network;
- Fig. 3: is a schematic block diagram illustrating an embodiment of an apparatus for controlling a gain of a receiver; and
- Fig. 4: is a flow chart illustrating a method embodiment of a method for controlling a gain of a receiver.

### Description of preferred embodiments

In the following, for purposes of explanation and not limitation, specific details are set forth, such as particular sequences of steps, interfaces and configurations, in order to provide a thorough understanding of the present invention. It will be apparent to one skilled in the art that the present invention may be practiced in other embodiments that depart from these specific details. For example, while the embodiments will be described with reference to an LTE telecommunication system, it will be apparent to the skilled person that the invention can also be practiced in context with other telecommunication systems.

Moreover, those skilled in the art will appreciate that the functions and processes explained herein below may be implemented using software functioning in conjunction with a programmed microprocessor or with general purpose computers. It will also be appreciated that while the embodiments are primarily described in the form of methods and apparatuses, the invention may also be embodiment in a computer program product as well as in a system comprising a computer processor and a memory coupled to the processor, wherein the memory is encoded with one or more programs that may perform the functions disclosed herein.

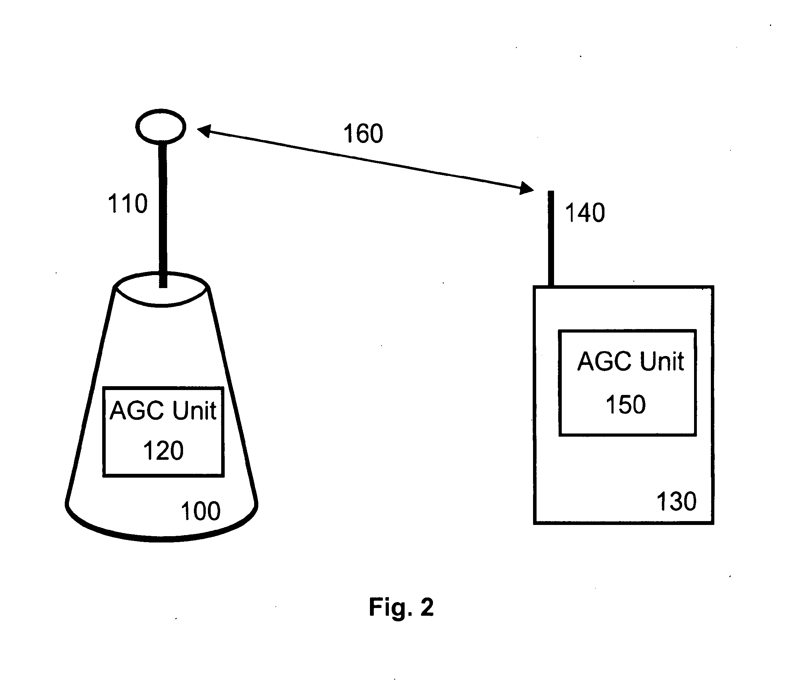

Fig. 2 shows a schematic block diagram illustrating an embodiment of a communication network. The communication network comprises a base station 100 and a mobile terminal 130. Base station 100 communicates via antenna 110 with mobile terminal 130, as indicated by arrow 160. Mobile terminal 130 communicates via antenna 140 with base station 100. In base station 100, received signals are provided to AGC unit 120. AGC unit 120 controls the receiver gain of base station 100. Similarly, in mobile terminal 130, received signals are provided to AGC unit 150. AGC unit 150 controls the receiver gain of mobile terminal 130.

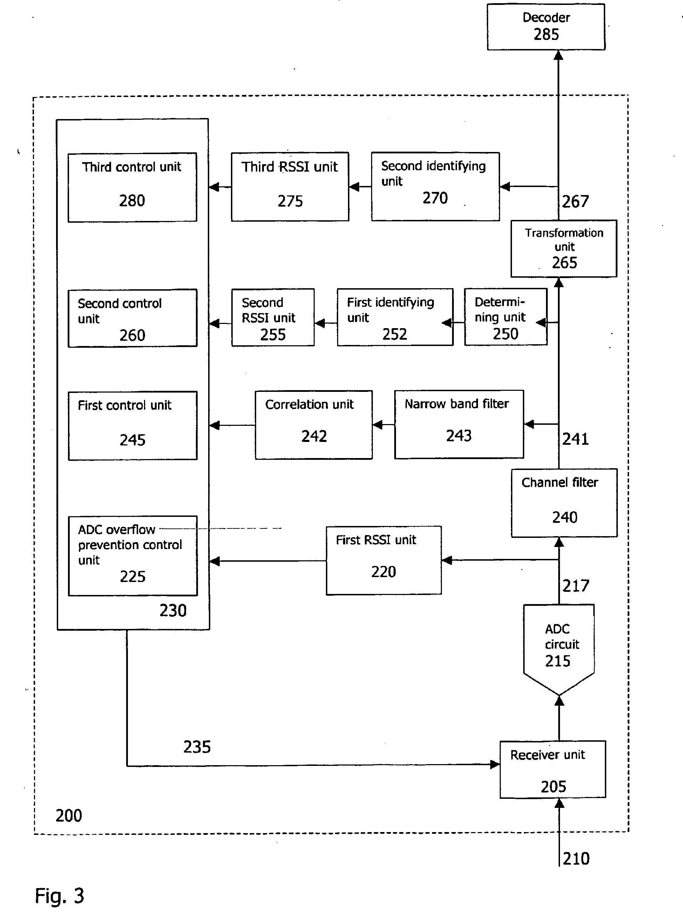

Fig. 3 shows a schematic block diagram illustrating an embodiment of an apparatus 200 for controlling a gain of a receiver. The receiver may, for example, be incorporated in a LTE terminal such as a mobile telephone. The apparatus 200 may also be the AGC unit 120 of the base station 100 and/or the AGC unit 150 of the mobile terminal 130 shown in Fig. 2.

The apparatus 200 is an LTE receiver comprising four control loops for controlling the gain of a receiver unit 205. The first control loop comprises the receiver unit 205, an ADC circuit 215, a first RSSI unit 220 and an ADC overflow prevention control unit 225. The second control loop is an AGC loop and comprises the receiver unit 205, the ADC circuit 215, a channel filter 240, a narrow band filter 243, a correlation unit 242 and a first control unit 245. The third control loop is also an AGC loop and comprises the receiver unit 205, the ADC circuit 215, the channel filter 240, a determining unit 250, a first identifying unit 252, a second RSSI unit 255 and a second control unit 260. The fourth control loop is a further AGC loop and comprises the receiver unit 205, the ADC circuit 215, the channel filter 240, a transformation unit 265, a second identifying unit 270, a third RSSI unit 275 and a third control unit 280. The ADC overflow prevention control unit 225, the first control unit 245, the second control unit 260 and the third control unit 280 are located within an AGC unit 230.

The radio receiver unit 205 receives from an antenna (not shown) via an air interface an input signal 210. The signal 210 is an LTE transmission data signal including P-SS, S-SS, BCH and RSIG signal parts having a substantially constant signal strength. The signal 210 could additionally include further signal parts, or one or more of the P-SS, S-SS, BCH and RSIG signal parts may at least temporally not be included in the signal 210.

The P-SS and S-SS signal parts convey network timing information and can be used by a mobile terminal during cell search procedures, i.e. after power on of the receiver and/or cell reselection. In LTE telecommunication systems, the P-SS is sent in slot No. 0 and slot No. 10 of a radio frame and occupies 72 sub-carriers. In slot No. 0 and slot No. 10, the P-SS is located in OFDM symbol 6. The S-SS is sent in LTE telecommunication systems in slot No. 0 and slot No. 10 of a radio frame and occupies 72 sub-carriers. The S-SS is located in OFDM symbol 6. P-SS and S-SS may be combined to form a physical cell identity, e.g. a cell specific identifier. For determining the P-SS, no knowledge regarding cell-specific parameters is necessary. However, for determining the S-SS, system knowledge regarding slot timing is necessary.

The BCH carries system information within a cell. System information is typically required during a cell search procedure. The BCH is mapped onto a Physical Broadcast Channel (PBCH). In LTE telecommunication systems, the PBCH is located in frame No. 1, sub-frame No. 1 in OFDM symbols 0 to 3 on 72 sub-carriers. For determining the BCH, system knowledge regarding frame timing and symbol structure (i.e. cyclic prefix length) is necessary.

The RSIG comprises channel estimation information. In LTE systems, for a normal cyclic prefix, the RSIG may for example be located in OFDM symbols No. 0, 4, 7, 11 in each sub-frame. For determining the RSIG, system information regarding cell bandwidth, frame timing and symbol structure (i.e. cyclic prefix length) is necessary.

In LTE systems, P-SS, S-SS and PBCH signals occupy the same frequency spectrum. However, they are non-overlapping in time. Moreover, P-SS, S-SS and PBCH together may provide frequency synchronisation. The synchronization signals may use the same type of pseudo-random sequence as the reference signal.

The synchronization signals P-SS and S-SS, the broadcast channel BCH and the reference signal RSIG of Evolved Universal Terrestrial Radio Access (E-UTRA) networks are described in more detail in document 3GPP TS 36.211 V8.0.0 "3rd Generation Partnership Project; Technical Specification Group Radio Access Network; Evolved Universal Terrestrial Radio Access (E-UTRA); Physical channels and modulation (Release 8)", which is herewith incorporated by reference in its entirety.

Returning now to Fig. 3, the received signal 210 is in an first step supplied to the ADC circuit 215 which generates an ADC signal 217. After analog-to-digital conversion of the received signal 210 by ADC circuit 215, the first RSSI unit 220 measures the total signal strength of the ADC signal 217. The measurement value is provided to the ADC overflow prevention control unit 225. Based on the measured total signal strength of the ADC signal 217, the ADC overflow prevention control unit 225 controls the gain of the receiver unit 205, i.e. provides a gain control signal 235 to the receiver unit 205, such that the gain of the receiver unit 205 is reduced as soon as the maximum power level of the ADC circuit 215 is reached. Thereby, bit overflow of the ADC circuit 215 and clipping is prevented.

After the analog-to-digital conversion 215, the ADC signal 217 is provided to the channel filter 240. Channel filter 240 removes blockers and other unwanted signals which are close to the desired signal spectrum. The bandwidth of the signal 241 filtered by channel filter 240 is the cell bandwidth.

The filtered signal 241 is narrow band filtered by narrow band filter 243 and subsequently provided to the correlation unit 242. The correlation unit 242 generates a correlation value for the primary synchronisation signal P-SS. The correlation value is determined based on a cross-correlation of the P-SS with a known P-SS reference signal. The higher the correlation value, the more similar the P-SS and the P-SS reference signal are.

The determined correlation value is subsequently provided to the first control unit 245. Based on the calculated correlation value, the first control unit 245 initially controls the gain of the receiver unit 205, i.e. provides a gain control signal 235 to the receiver unit 205. Thus, by means of the first control unit 245, a coarse control of the receiver gain during the timing acquisition phase, i.e. after power on of the receiver or cell reselection, of the receiver 200 is provided. During the initial timing acquisition phase of the receiver, no signal strength measurement of the P-SS may be possible, since the P-SS does not occupy the whole time axis but shares it with channels having high dynamics. However, initial control of the receiver gain based on the P-SS correlation value is possible. No knowledge regarding cell-specific parameters is necessary for this initial control based on the P-SS.

Subsequent to the initial controlling by means of the first control unit 245, a further controlling, which is providing a more exact control 235 of the gain of the receiver unit 205, is provided. For the further controlling, the filtered signal 241 is provided to the determining unit 250 which is determining at least one timing-related parameter of the filtered signal 241.

In the present embodiment, the determining unit 250 determines the coarse frame timing of the filtered signal 241 based on the correlated P-SS. However, the determining unit 250 may as well determine the at least one timing-related parameter of the filtered signal 241 based on two or more parts of the filtered signal 241 having a substantially constant signal strength. For example, the timing-related parameter may be determined based on the correlated primary and secondary synchronisation signals P-SS and S-SS. The timing-related parameter may also comprise slot timing and/or symbol timing.

Subsequent to the determining of the frame timing by the determining unit 250, the first identifying unit 252 identifies at least a second part of the received signal having a substantially constant signal strength based on the at least one timing-related parameter determined by the determining unit 250. The first identifying unit 252 may be a filter unit.

In an alternative embodiment (not shown), the determining unit 250 and the first identifying unit 252 may also be interchanged. In this embodiment, the first identifying unit 252 identifies at least a second part of the received signal having a substantially constant signal strength before the determining unit 250 determines the frame timing.

In the present embodiment, the BCH is identified by the first identifying unit 252 by means of the determined frame timing. Thereafter, the second RSSI unit 255 measures the signal strength of the BCH. The measured signal strength of the BCH is provided to the second control unit 260. The second control unit 260 controls the gain of the receiver unit 205, i.e. provides a gain control signal 235 to the receiver unit 205, based on the BCH signal strength measured by the second RSSI unit 255. The second RSSI unit 255 may alternatively or additionally measure the signal strength of P-SS and/or S-SS. In this case, the first identifying unit 252 alternatively or additionally identifies P-SS and/or S-SS and the second control unit 260 controls 235 the gain of the receiver unit 205 based on the signal strength of at least one of BCH, P-SS and S-SS.

Subsequent to the further controlling of the gain of the receiver unit 205, a fine controlling of the gain of the receiver unit 205 is provided. To this end, the filtered signal 241 is provided to the transformation unit 265. The transformation unit 265 is providing an OFDM demodulation using a FFT. For the transformation of the filtered signal 241 into the frequency domain, the OFDM symbol timing has to be known. Accordingly, a determination of the OFDM symbol timing (not shown in Fig. 3) may be provided prior to the transformation into the frequency domain.

After the transformation of the filtered signal 241 into the frequency domain, the transformed signal 267 is provided to the second identifying unit 270. The second identifying unit 270 may be a filter unit. The second identifying unit 270 extracts the RSIG from the transformed signal 267. Thereafter, the third RSSI unit 275 measures the signal strength of the RSIG extracted by the second identifying unit 270. The measured signal strength of the RSIG is provided to the third control unit 280. The third control unit 280 is performing a fine controlling of the gain of the receiver unit 205 based on the measured signal strength of the RSIG, i.e. is providing a gain control signal 235 to the receiver unit 205.

After passing the apparatus for controlling the receiver gain 200, the signal 267 is provided to a decoder 285 for further processing.

In the embodiment according to Fig. 3, the first control unit 245, the second control unit 260 and the third control unit 280 perform subsequent controlling, i.e. coarse, further and fine controlling, of the gain of the receiver unit 205. The ADC overflow prevention control unit 225 controls in parallel the gain of the receiver unit 205 so that ADC bit overflow and clipping is prevented. In other embodiments, the second 260 and the third 280 control unit, i.e. the further and the fine controlling, may also be combined or interchanged. It is also possible that in addition to the first control unit 245, only one of the second control unit 260 and the third control unit 280 is provided.

In order to further reduce the risk of clipping and to more efficiently use the ADC bits, the second control unit 260 may control the gain of the receiver unit 205 so that a minimum SNR value of the receiver unit 205 is reached.

In known AGC schemes, the receiver gain is controlled so that a constant offset to the ADC limit values is provided. In particular, the receiver gain is controlled in that the average signal power of the receiver is provided with a constant power level below the ADC peak power level. Thus, in known AGC schemes, the received signal power is controlled with respect to an ADC peak level, e.g. the ADC Most Significant Bit (ADC MSB).

However, due to the dynamic power changes in LTE telecommunication systems, the above control target of known AGC schemes would result in either too high ADC offset values, which may lead to an inefficient use of ADC bits, or a risk of occasional clipping, which may lead to a deterioration of the system performance. Thus, contrary to controlling the received signal power with respect to an ADC MSB, the second control unit 260 may control the gain of the receiver unit 205 so that a minimum SNR value of the receiver unit 205 is reached. In particular, the received signal power may be controlled with respect to an ADC bottom level, e.g. the ADC Least Significant Bit (ADC LSB). Thereby, full bit resolution is provided. Furthermore, by controlling the receiver gain so that a target SNR value is reached, an efficient use of the ADC bits is provided which reduces the risk of clipping.

Thereby, a maximum offset to the maximum input level of the ADC circuit 215 is provided. This is advantageous, since the second control unit 260 only considers a part or parts of the received signal having substantially constant signal strength which are identified by the first identifying unit 252 and not the entire signal.

The third control unit 280 may also control the gain of the receiver unit 205 so that a minimum SNR value of the receiver unit 205 is reached. Thereby, the risk of clipping is reduced and the ADC bits are used in an efficient way.

The target SNR value may be chosen such that a maximum SNR value among all physical channels which have to be decoded in a certain time frame is reached. In order to estimate a suitable target SNR value, signal strength measurements of parts of the received signal having a substantially constant signal strength may be combined. For example, the measured signal strengths of P-SS, S-SS and BCH may be combined. Contrary to the initial controlling and the controlling the receiver gain based on the RSIG, a combination of P-SS, S-SS and BCH includes interference signals from other cells.

In an alternative embodiment, the signal path comprising the narrow band filter 243, the correlation unit 242 and the first control unit 245 and the signal path comprising the determining unit 250, the first identifying unit 252, the second RSSI unit 255 and the second control unit 260 may be combined. For example, one filter unit which is capable of providing several filtering functions, e.g. P-SS and S-SS filtering, may be provided for both circuit paths. The one filter unit may provide the filtered, i.e. the extracted signal, to the correlation unit 242 and the second RSSI unit 255 for subsequent controlling of the receiver gain in the respective control units 245 and 260.

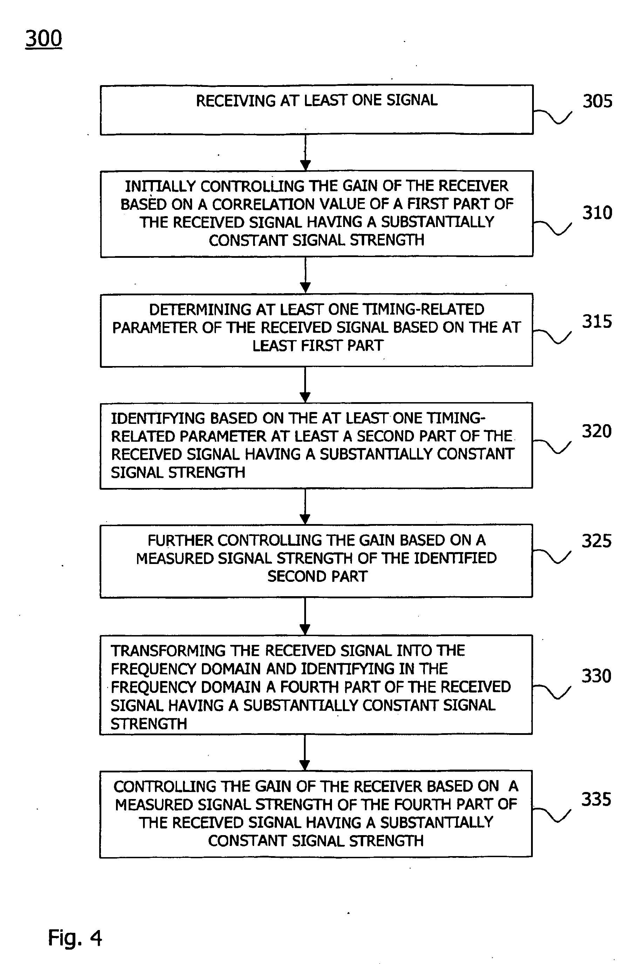

Fig. 4 shows a flow chart illustrating a method embodiment of a method for controlling a gain of a receiver. The method 300 may be practiced by the apparatus 200 shown in Fig. 3 or by any other apparatus requiring AGC.

The method starts in step 305 by receiving at least one signal by a receiver. The signal may be received via an air interface from a base station. Thereafter, in step 310, the gain of the receiver is initially controlled based on a correlation value of a first part of a received signal having a substantially constant signal strength. For example, the initial controlling may be based on a correlation value of P-SS.

Subsequently, in step 315, at least one timing-related parameter of the received signal is determined based on the at least first part. For example, based on the correlated P-SS value, the frame timing of the received signal may be determined.

By means of the at least one timing-related parameter, at least a second part of the received signal having a substantially constant signal strength is identified in step 320. For example, based on the frame timing, the BCH, the P-SS or the S-SS may be determined.

After the initial controlling of the gain of the receiver, a further controlling of the gain of the receiver is provided in step 325. In particular, the gain of the receiver is controlled based on a measured signal strength of the identified second part. For example, the further controlling 325 may be based on a measured signal strength of the P-SS, the S-SS and/or the BCH.

After the initial controlling 310 and the further controlling 325, the received signal is transformed in step 330 into the frequency domain and a fourth part of the received signal having a substantially constant signal strength is determined. For example, the RSIG may be identified in the frequency domain. Thereafter, the gain of the receiver is fine controlled based on a measured signal strength of the fourth part of the received signal having a substantially constant signal strength, as indicated in step 335. As an example, the gain of the receiver may be fine controlled based on the measured signal strength of the RSIG.

A technique for controlling a gain of a receiver which is receiving shared channels having high dynamics is provided. The technique is based on a multi step approach. Dependent on which system parameters are available in a certain control phase, each control step may make use of different system parameters. Only parts of a received downlink signal that are transmitted with a substantially constant signal strength (and not the entire downlink signal) are considered for the controlling of the receiver gain. Thus, slow path loss variations caused by shadowing are compensated. The technique does not react on fast fading. Thus, the stability and robustness of the controlling of the receiver gain is improved, in particular in comparison with conventional concepts that attempt to track the fast fading process of AGC schemes. Furthermore, the system parameters are exploited in an efficient way. ADC bits are used efficiently and ADC bit overflow and clipping is prevented.

Although the proposed technique for controlling a gain of a receiver is explained by means of a LTE mobile terminal, in particular a LTE receiver in a LTE telecommunication system, the proposed technique is not limited to LTE telecommunication system. In principle, the proposed technique may be used in any other telecommunication system having dynamically varying input signals. Moreover, while the embodiments focus on OFDM-based downlink transmission, the present technique can also be used in an uplink direction (e.g., in a base station receiver) in which, in LTE and similar systems, SC-FDMA is used.

Although embodiments of the proposed technique have been illustrated in the accompanying drawings and described in the description, it will be understood that the invention is not limited to the embodiments disclosed herein. In particular, the proposed technique is capable of numerous rearrangements, modifications and substitutions without departing from the scope of the invention as set forth and defined by the following claims.

## Claims

1. A method for controlling a gain of a receiver, comprising the steps of:
- receiving (305) at least one signal;
- cross-correlating an unknown first part of the received signal having a substantially constant signal strength with a known reference signal or a number of known reference signals in order to obtain a correlation value;
- initially, during a timing acquisition phase of the receiver, controlling (310) the gain based on the correlation value;
- determining (315) at least one timing-related parameter of the received signal based on the at least first part;
- identifying (320) based on the at least one timing-related parameter at least a second part of the received signal having a substantially constant signal strength; and
- further controlling (325) the gain based on a measured signal strength of the identified second part.

2. The method of claim 1, wherein the first part of the received signal is a synchronization signal comprising slot synchronization information.

3. The method of claim 1 or 2, wherein the second part of the received signal comprises at least one of a synchronization signal comprising slot synchronization information, a synchronization signal comprising frame synchronization information, a transport channel comprising system information and a reference signal comprising channel estimation information.

4. The method of any of the preceding claims, wherein the at least one timing-related parameter is associated with at least one of a slot timing, a frame timing and a symbol timing of the received signal.

5. The method of any of the preceding claims, wherein the at least one timing-related parameter of the received signal is determined based on the first part and a further part of the received signal having a substantially constant signal strength.

6. The method of any of the preceding claims, wherein the further controlling (325) comprises controlling the gain based on a measured signal strength of at least one of the first part, the second part and a third part of the received signal having a substantially constant signal strength.

7. The method of any of the preceding claims, further comprising the step of:
- controlling (330) the gain based on a measured signal strength of a fourth part of the received signal having a substantially constant signal strength.

8. The method of claim 7, wherein the initial controlling (310), the further controlling (325) and the controlling (330) based on a measured signal strength of the fourth part are performed subsequent to each other.

9. The method of any of the preceding claims, further comprising the steps of:
- transforming (335) the received signal into the frequency domain; and
- identifying in the frequency domain the fourth or a further part of the received signal having a substantially constant signal strength.

10. The method of any of the preceding claims, wherein the gain is controlled so that a target signal-to-noise-rado (SNR) value is reached.

11. The method of claim 10, wherein the target signal-to-noise-ratio (SNR) value is a minimum signal-to-noise-ratio (SNR) value.

12. The method of any of the preceding claims, further comprising the steps of:
- determining a total signal strength of the received signal; and
- controlling the gain based on the determined total signal strength.

13. The method of any of the preceding claims, wherein the received signal is narrow band filtered before the initial controlling.

14. A computer program product including program code portions for performing the method steps according to one of the preceding claims, when the computer program product is run on one or more components of a network.

15. The computer program product according to claim 14, stored on a computer-readable recording medium.

16. An apparatus (200) for controlling a gain of a receiver comprising:
- a receiving unit (205) for receiving at least one signal;
- a correlating unit (242) for cross-correlating an unknown first part of the received signal having a substantially constant signal strength with a known reference signal or a number of known reference signals in order to obtain a correlation value;
- a first controlling unit (245) for initially, during a timing acquisition phase of the receiver, controlling the gain based on the correlation value;
- a determining unit (250) for determining at least one timing-related parameter of the received signal based on the at least first part;
- a first identifying unit (252) for identifying based on the at least one timing-related parameter at least a second part of the received signal having a substantially constant signal strength; and
- a second controlling unit (260) for further controlling the gain based on a measured signal strength of the identified second part.

17. The apparatus of claim 16, further comprising:
- a second identifying unit (270) for identifying a third part of the received signal having a substantially constant signal strength, wherein the at least one timing-related parameter of the received signal is determined based on the identified first part and a further part of the received signal having a substantially constant signal strength.

18. The apparatus according of claim 16 or 17, further comprising:
- a third controlling unit (280) for controlling the gain based on a measured signal strength of a fourth part of the received signal having a substantially constant signal strength.

19. A mobile terminal (130) comprising the apparatus of any one of claims 16 to 18.

20. A base station (100) comprising the apparatus of any one of claims 16 to 18.

## Patentansprüche

1. Verfahren zum Regeln einer Verstärkung eines Empfängers, umfassend die folgenden Schritte:
- Empfangen (305) wenigstens eines Signals;
- Kreuzkorrelieren eines unbekannten ersten Teils des empfangenen Signals mit einer im Wesentlichen konstanten Signalstärke mit einem bekannten Referenzsignal oder einer Anzahl von bekannten Referenzsignalen, um einen Korrelationswert zu erhalten;
- anfängliches Regeln (310) während einer Takterfassungsphase des Empfängers der Verstärkung auf der Basis des Korrelationswerts;
- Bestimmen (315) wenigstens eines taktbezogenen Parameters des empfangenen Signals auf der Basis des wenigstens einen Teils;
- Identifizieren (320) auf der Basis des wenigstens einen taktbezogenen Parameters wenigstens eines zweiten Teils des empfangenen Signals mit einer im Wesentlichen konstanten Signalstärke; und
- weiteres Regeln (325) der Verstärkung auf der Basis einer gemessenen Signalstärke des identifizierten zweiten Teils.

2. Verfahren nach Anspruch 1, wobei der erste Teil des empfangenen Signals ein Synchronisierungssignal mit Schlitzsynchronisierungsinformationen ist.

3. Verfahren nach Anspruch 1 oder 2, wobei der zweite Teil des empfangenen Signals wenigstens eines von einem Synchronisierungssignal mit Schlitzsynchronisierungsinformationen, einem Synchronisierungssignal mit Rahmensynchronisierungsinformationen, einem Transportkanal mit Systeminformationen und einem Referenzsignal mit Kanalschätzungsinformationen umfasst.

4. Verfahren nach einem der vorhergehenden Ansprüche, wobei der wenigstens eine taktbezogene Parameter mit wenigstens einem von einem Schlitztakt, einem Rahmentakt und einem Symboltakt des empfangenen Signals assoziiert ist.

5. Verfahren nach einem der vorhergehenden Ansprüche, wobei der wenigstens eine taktbezogene Parameter des empfangenen Signals auf der Basis des ersten Teils und eines weiteren Teils des empfangenen Signals mit einer im Wesentlichen konstanten Signalstärke bestimmt wird.

6. Verfahren nach einem der vorhergehenden Ansprüche, wobei das weitere Regeln (325) ein Regeln der Verstärkung auf der Basis einer gemessenen Signalstärke von wenigstens einem von dem ersten Teil, dem zweiten Teil und einem dritten Teil des empfangenen Signals mit einer im Wesentlichen konstanten Signalstärke umfasst.

7. Verfahren nach einem der vorhergehenden Ansprüche, ferner umfassend den folgenden Schritt:
- Regeln (330) der Verstärkung auf der Basis einer gemessenen Signalstärke eines vierten Teils des empfangenen Signals mit einer im Wesentlichen konstanten Signalstärke.

8. Verfahren nach Anspruch 7, wobei das anfängliche Regeln (310), das weitere Regeln (325) und das Regeln (330) auf der Basis einer gemessenen Signalstärke des vierten Teils nacheinander durchgeführt werden.

9. Verfahren nach einem der vorhergehenden Ansprüche, ferner umfassend die folgenden Schritte:
- Umformen (335) des empfangenen Signals in den Frequenzbereich; und
- Identifizieren im Frequenzbereich des vierten oder eines weiteren Teils des empfangenen Signals mit einer im Wesentlichen konstanten Signalstärke.

10. Verfahren nach einem der vorhergehenden Ansprüche, wobei die Verstärkung so geregelt wird, dass ein Signal-Rausch-Verhältnis (SNR)-Zielwert erreicht wird.

11. Verfahren nach Anspruch 10, wobei der Signal-Rausch-Verhältnis (SNR)-Zielwert ein Signal-Rausch-Verhältnis (SNR)-Mindestwert ist.

12. Verfahren nach einem der vorhergehenden Ansprüche, ferner umfassend die folgenden Schritte:
- Bestimmen einer Gesamtsignalstärke des empfangenen Signals; und
- Regeln der Verstärkung auf der Basis der bestimmten Gesamtsignalstärke.

13. Verfahren nach einem der vorhergehenden Ansprüche, wobei das empfangene Signal vor dem anfänglichen Regeln schmalbandgefiltert wird.

14. Computerprogrammprodukt, umfassend Programmcodeabschnitte zum Durchführen der Verfahrenschritte nach einem der vorhergehenden Ansprüche, wenn das Computerprogrammprodukt auf einer oder mehreren Komponenten eines Netzwerks ausgeführt wird.

15. Computerprogrammprodukt nach Anspruch 14, gespeichert auf einem computerlesbaren Aufzeichnungsmedium.

16. Vorrichtung (200) zum Regeln einer Verstärkung eines Empfängers, umfassend:
- eine Empfangseinheit (205) zum Empfangen wenigstens eines Signals;
- eine Korrelationseinheit (242) zum Kreuzkorrelieren eines unbekannten ersten Teils des empfangenen Signals mit einer im Wesentlichen konstanten Signalstärke mit einem bekannten Referenzsignal oder einer Anzahl von bekannten Referenzsignalen, um einen Korrelationswert zu erhalten;
- eine erste Regeleinheit (245) zum anfänglichen Regeln während einer Takterfassungsphase des Empfängers der Verstärkung auf der Basis des Korrelationswerts;
- eine Bestimmungseinheit (250) zum Bestimmen wenigstens eines taktbezogenen Parameters des empfangenen Signals auf der Basis des wenigstens einen Teils;
- eine erste Identifizierungseinheit (252) zum Identifizieren auf der Basis des wenigstens einen taktbezogenen Parameters wenigstens eines zweiten Teils des empfangenen Signals mit einer im Wesentlichen konstanten Signalstärke; und
- eine zweite Regeleinheit (260) zum weiteren Regeln der Verstärkung auf der Basis einer gemessenen Signalstärke des identifizierten zweiten Teils.

17. Vorrichtung nach Anspruch 16, ferner umfassend:
- eine zweite Identifizierungseinheit (270) zum Identifizieren eines dritten Teils des empfangenen Signals mit einer im Wesentlichen konstanten Signalstärke, wobei der wenigstens eine taktbezogene Parameter des empfangenen Signals auf der Basis des identifizierten ersten Teils und eines weiteren Teils des empfangenen Signals mit einer im Wesentlichen konstanten Signalstärke bestimmt wird.

18. Vorrichtung nach Anspruch 16 oder 17, ferner umfassend:
- eine dritte Regeleinheit (280) zum Regeln der Verstärkung auf der Basis einer gemessenen Signalstärke eines vierten Teils des empfangenen Signals mit einer im Wesentlichen konstanten Signalstärke.

19. Mobiles Endgerät (130), umfassend die Vorrichtung nach einem der Ansprüche 16 bis 18.

20. Basisstation (100), umfassend die Vorrichtung nach einem der Ansprüche 16 bis 18.

## Revendications

1. Procédé de contrôle d'un gain d'un récepteur, comprenant les étapes consistant à :
- recevoir (305) au moins un signal ;
- effectuer une corrélation croisée d'une première partie inconnue du signal reçu ayant une intensité de signal substantiellement constante avec un signal de référence connu ou un certain nombre de signaux de référence connus afin d'obtenir une valeur de corrélation ;
- initialement, pendant une phase d'acquisition de temporisation du récepteur, contrôler (310) le gain sur la base de la valeur de corrélation ;
- déterminer (315) au moins un paramètre relatif à la temporisation du signal reçu sur la base d'au moins la première partie ;
- identifier (320) sur la base d'au moins un paramètre relatif à la temporisation au moins une seconde partie du signal reçu ayant une intensité de signal substantiellement constante ; et
- contrôler davantage (325) le gain sur la base d'une intensité de signal mesurée de la seconde partie identifiée.

2. Procédé selon la revendication 1, dans lequel la première partie du signal reçu est un signal de synchronisation comprenant une information de synchronisation de créneau temporel.

3. Procédé selon la revendication 1 ou 2, dans lequel la seconde partie la seconde partie du signal reçu comprend au moins un d'un signal de synchronisation comprenant une information de synchronisation de créneau temporel, un signal de synchronisation comprenant une information de synchronisation de trame, un canal de transport comprenant une information de système et un signal de référence comprenant une information d'estimation de canal.

4. Procédé selon une quelconque des revendications précédentes, dans lequel le au moins un paramètre relatif à la temporisation est associé à au moins une d'une temporisation de créneau temporel, une temporisation de trame et une temporisation de symbole du signal reçu.

5. Procédé selon une quelconque des revendications précédentes, dans lequel le au moins un paramètre relatif à la synchronisation du signal reçu est déterminé sur la base de la première partie et d'une autre partie du signal reçu ayant une intensité de signal substantiellement constante.

6. Procédé selon une quelconque des revendications précédentes, dans lequel le contrôle supplémentaire (325) comprend de contrôler le gain sur la base d'une intensité de signal mesurée d'au moins une de la première partie, la seconde partie et une troisième partie du signal reçu ayant une intensité de signal substantiellement constante.

7. Procédé selon une quelconque des revendications précédentes, comprenant en outre l'étape consistant à :
- contrôler (330) le gain sur la base d'une intensité de signal mesurée d'une quatrième partie du signal reçu ayant une intensité de signal substantiellement constante.

8. Procédé selon la revendication 7, dans lequel le contrôle initial (310), le contrôle supplémentaire (325) et le contrôle (330) basé sur une intensité de signal mesurée de la quatrième partie sont effectués l'un à la suite de l'autre.

9. Procédé selon une quelconque des revendications précédentes, comprenant en outre les étapes consistant à :
- transformer (335) le signal reçu en le domaine de fréquence ; et
- identifier dans le domaine de fréquence la quatrième ou une autre partie du signal reçu ayant une intensité de signal substantiellement constante.

10. Procédé selon une quelconque des revendications précédentes, dans lequel le gain est contrôlé de sortie qu'une valeur de rapport signal sur bruit (SNR) cible soit atteinte.

11. Procédé selon la revendication 10, dans lequel la valeur de rapport signal sur bruit (SNR) cible est une valeur de rapport signal sur bruit (SNR) minimale.

12. Procédé selon une quelconque des revendications précédentes, comprenant en outre les étapes consistant à :
- déterminer une intensité de signal totale du signal reçu ; et
- contrôler le gain sur la base de l'intensité de signal totale déterminée.

13. Procédé selon une quelconque des revendications précédentes, dans lequel le signal reçu est filtré sur bande étroite avant le contrôle initial.

14. Produit de programme informatique incluant des portions de code de programme pour mettre en oeuvre les étapes de procédé selon une des revendications précédentes, quand le produit de programme informatique est exécuté sur un ou plusieurs composants d'un réseau.

15. Produit de programme informatique selon la revendication 14, mémorisé sur un support d'enregistrement lisible par ordinateur.

16. Appareil (200) pour contrôler un gain d'un récepteur comprenant :
- une unité de réception (205) pour recevoir au moins un signal ;
- une unité de corrélation (242) pour effectuer une corrélation croisée d'une première partie inconnue du signal reçu ayant une intensité de signal substantiellement constante avec un signal de référence connu ou un certain nombre de signaux de référence connus afin d'obtenir une valeur de corrélation ;
- une première unité de contrôle (245) pour contrôler initialement, pendant une phase d'acquisition de temporisation du récepteur, le gain sur la base de la valeur de corrélation ;
- une unité de détermination (250) pour déterminer au moins un paramètre relatif à la temporisation du signal reçu sur la base de la au moins première partie ;
- une première unité d'identification (252) pour identifier sur la base d'au moins un paramètre relatif à la temporisation au moins une seconde partie du signal reçu ayant une intensité de signal substantiellement constante ; et
- une seconde unité de contrôle (260) pour contrôler davantage le gain sur la base d'une intensité de signal mesurée de la seconde partie identifiée.

17. Appareil selon la revendication 16, comprenant en outre .
- une seconde unité d'identification (270) pour identifier une troisième partie du signal reçu ayant une intensité de signal substantiellement constante, dans lequel le au moins un paramètre relatif à la temporisation du signal reçu est déterminé sur la base de la première partie identifiée et d'une autre partie du signal reçu ayant une intensité de signal substantiellement constante.

18. Appareil selon la revendication 16 ou 17, comprenant en outre .
- une troisième unité de contrôle (280) pour contrôler le gain sur la base d'une intensité de signal mesurée d'une quatrième partie du signal reçu ayant une intensité de signal substantiellement constante.

19. Terminal mobile (130) comprenant l'appareil selon une quelconque des revendications 16 à 18.

20. Station de base (100) comprenant l'appareil selon une quelconque des revendications 16 à 18.
